# EUROPEAN PATENT SPECIFICATION

(11) **EP 1 262 994 B1**
(45) Date of publication and mention of the grant of the patent: **30.03.2005**
(21) Application number: 02102037.5
(22) Date of filing: 25.07.1996
(51) Int. Cl.: G11C 7/00, G11C 11/409

(54) **An apparatus and method for a data path implemented using non-differential current mode techniques**
Anordnung und Verfahren zur Ausführung eines Datenpfads mit Gebrauch von nicht differentieller Strommodustechnik
Appareil et méthode d'implementation d'un bus de donnée utilisant des techniques de mode de courant non différentiel

(43) Date of publication of application: 04.12.2002
(62) Divisional of application: 96305453.1
(73) Proprietor: Texas Instruments Incorporated, Dallas, Texas 75251 (US)
(72) Inventor: HAUKNESS, Brent S., 90532 - California (US)
(74) Representative: Holt, Michael

(56) References cited:
- EP-A- 0 353 508
- US-A- 4 797 583
- US-A- 5 262 984

## Description

### BACKGROUND OF THE INVENTION

### FIELD OF THE INVENTION

This invention relates generally to dynamic random access memory (DRAM) units and, more particularly, to the signal paths which couple the local input/output (I/O) devices and the storage cells in dynamic semiconductor memories.

### DESCRIPTION OF THE RELATED ART

In order to increase the speed of DRAM units, the use of current-mode techniques, as opposed to voltage mode techniques have been proposed to minimize the effect of parasitic capacitance over long data lines. However, typical current-mode circuits are implemented using differential circuit techniques. While the differential techniques have the advantage that the two interconnect lines simplify the detection of the signal, the two interconnect lines provide an undesirable increase in the area required to implement the signal path on the semiconductor chip.

A need has therefore been felt for apparatus and an associated technique which can take advantage of the increased speed of the current-mode techniques without incurring the penalty of increased implementing area.

### SUMMARY OF THE INVENTION

The invention is defined by claims 1, 11 and 22.

The aforementioned and other features are accomplished, according to the present invention, by apparatus for converting the differential output signals from the sense amplifiers of a dynamic random access memory unit to a non-differential current mode signal. The current mode signal is applied to a data line. The non-differential current mode Signal transmitted by the data line is applied to apparatus which converts the current mode signal first to a small swing voltage signal and then to a large swing voltage signal suitable for use with circuits coupled to the dynamic random access memory unit. To convert the small swing voltage signal to a large swing voltage signal, sample and hold apparatus stores a reference signal against which the small swing voltage signal is compared. The comparison of the reference signal and the small voltage signal determined by the logic state detected by the sense amplifiers generates a full voltage swing output signal.

### BRIEF DESCRIPTION OF THE DRAWINGS

The present invention will now be further described, by way of example with reference to the accompanying drawings in which;
Figure 1 is a block diagram of the data path non-differential current mode apparatus of the present invention;
Figure 2 is a schematic circuit diagram of the data path non-differential current mode apparatus of the present invention;
Figure 3 illustrates a simulated READ '0' transition for the present invention; and
Figure 4 illustrates a simulated READ '1' transition for the present invention.

### DESCRIPTION OF THE PREFERRED EMBODIMENTS

### DETAILED DESCRIPTION OF THE DRAWINGS

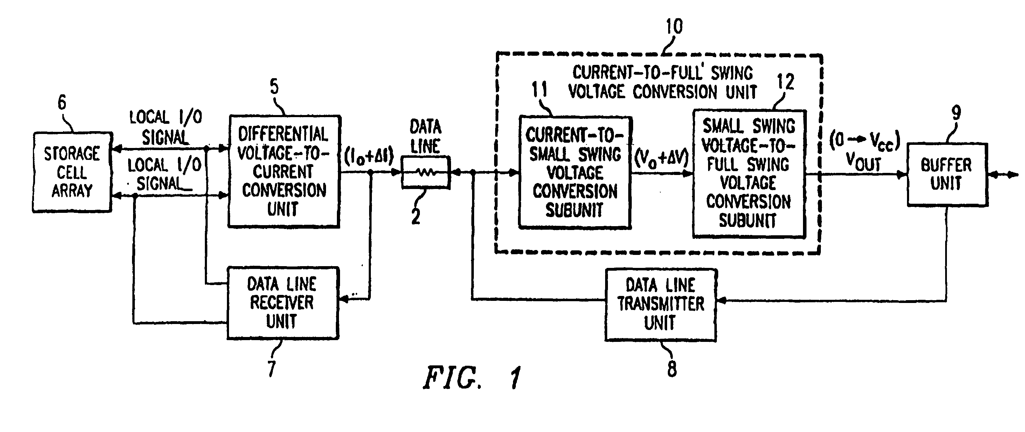

Referring now to Fig. 1, a block diagram of the non-differential, current mode data path, according to the present invention, along with associated memory components of a memory unit, for retrieving data from a storage cell array is shown. The local input/output signal (LOCAL I/O SIGNAL) and the logical complement (LOCAL I/O SIGNAL_), both from the storage cell array 6 is applied to the differential voltage-to-current conversion unit 5. The output signal (Iₒ ± DELTA I) from the differential signal-to-current conversion unit is applied through the data line 2 to the current-to-small swing voltage conversion sub-unit 11 of the current-to-full swing voltage conversion unit 10. The output signal (Vₒ ± DELTA V) from the current-to-small swing voltage conversion sub-unit is applied to the small swing voltage-to-full swing voltage conversion subunit 12, sub-unit 12 providing the output signal V_{OUT} (0→V_{DD}) for the non-differential, current mode data path. This signal V_{OUT} is applied to buffer unit 9. For storing data in the storage cell array 6, buffer unit 9 applies signals through data line transmitter 8 to the data line 2. The signals transmitted by the data line 2 are applied through data line receiver unit 7 to the LOCAL I/O signal terminal and the LOCAL I/O_ signal terminals to the storage cell array 6.

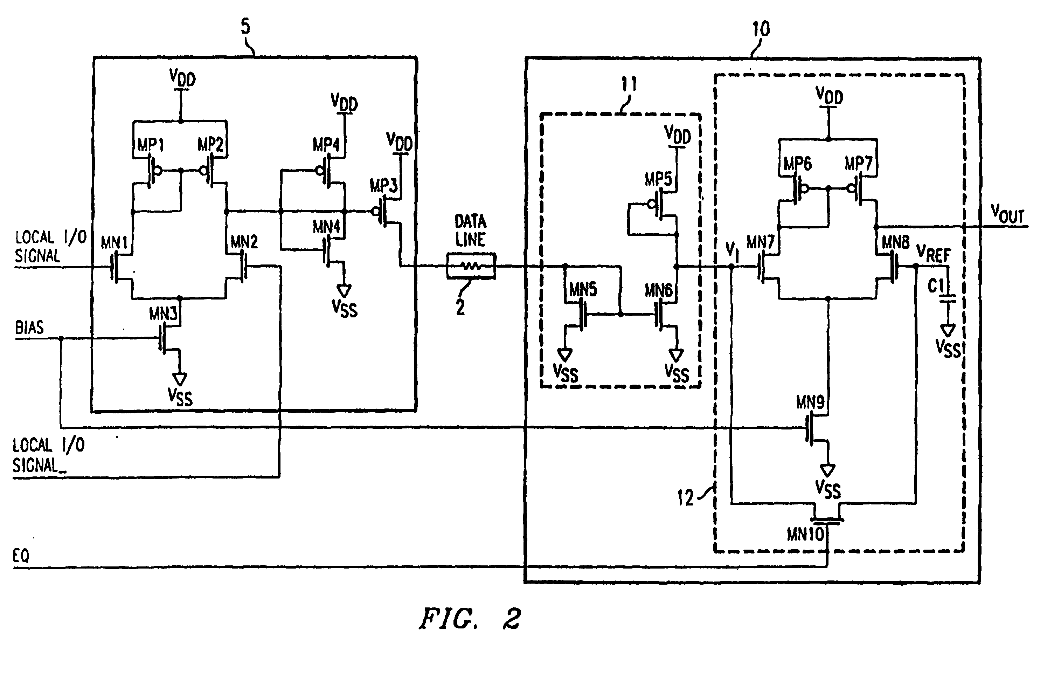

Referring to Fig. 2, a schematic diagram of the non-differential, current mode data path, according to the present invention, is shown. The LOCAL I/O SIGNAL is applied to a gate terminal of N-channel field effect transistor MN1, while the LOCAL I/O SIGNAL_ is applied to a gate terminal of N-channel field effect transistor MN2. The BIAS SIGNAL is applied to a gate terminal of n-channel field effect transistor MN3 and to a gate terminal of n-channel field effect transistor MN9, while a source terminal of transistor MN3 is coupled to supply terminal Vₛₛ. A drain terminal of transistor MN3 is coupled to a source terminal of transistor MN1 and to a source terminal of transistor MN2. A drain terminal of transistor MN1 is coupled to a drain and a gate terminal of p-channel field effect transistor MP1 and to a gate terminal of p-channel field effect transistor MP2. The source terminal of transistor MP1 and the source terminal of transistor MP2 are coupled to supply terminal V_{DD}. The drain terminal of transistor MP2 is coupled to a drain terminal of transistor MN2, to a gate and drain terminal of p-channel field effect transistor MP4, to a gate and a drain terminal of n-channel field effect transistor MN4, and to a gate terminal of P-channel field effect transistor MP3. The source terminal of transistor MN4 is coupled to voltage supply terminal V_{SS}. The source terminal of transistor MP4 and the source terminal of transistor MP3 are coupled to the voltage supply terminal V_{DD}. The drain terminal of transistor MP3 is coupled through data line RES10 to a drain and a gate terminal of n-channel field effect transistor MN5 and to a gate terminal of n-channel field effect transistor MN6. The data line RES10 has both distributed resistance and distributed capacitance associated therewith. The source terminal transistor MN5 and the drain terminal of transistor MN6 are coupled to the voltage supply terminal Vss. A drain terminal of transistor MN6 is coupled to a drain and a gate terminal of p-channel transistor MP5, to a gate terminal of transistor of n-channel field effect transistor MN7, and to a drain terminal of n-channel field effect transistor MN10. The source terminal of transistor MP5 is coupled to the voltage supply terminal V_{DD}. A drain terminal of transistor MN7 is coupled to a drain terminal and a gate terminal of p-channel field effect transistor MP6 and to a gate terminal of p-channel transistor field effect transistor MP7. A source terminal of transistor MP6 and a source terminal of transistor MP7 are coupled to the voltage supply terminal V_{DD}. A source terminal of transistor MN7 is coupled to a drain terminal of transistor MN9 and a source terminal of n-channel field effect transistor MN8. A source terminal of transistor MN9 is coupled to the voltage supply terminal V_{SS}. A gate terminal of transistor MN10 is coupled to an EQ SIGNAL. A source terminal of transistor MN10 is coupled to a gate terminal of transistor MN8 and through capacitor C1 to the voltage supply terminal vₛₛ. A drain terminal of transistor MN8 and a drain terminal of transistor MP7 are coupled to the output terminal.

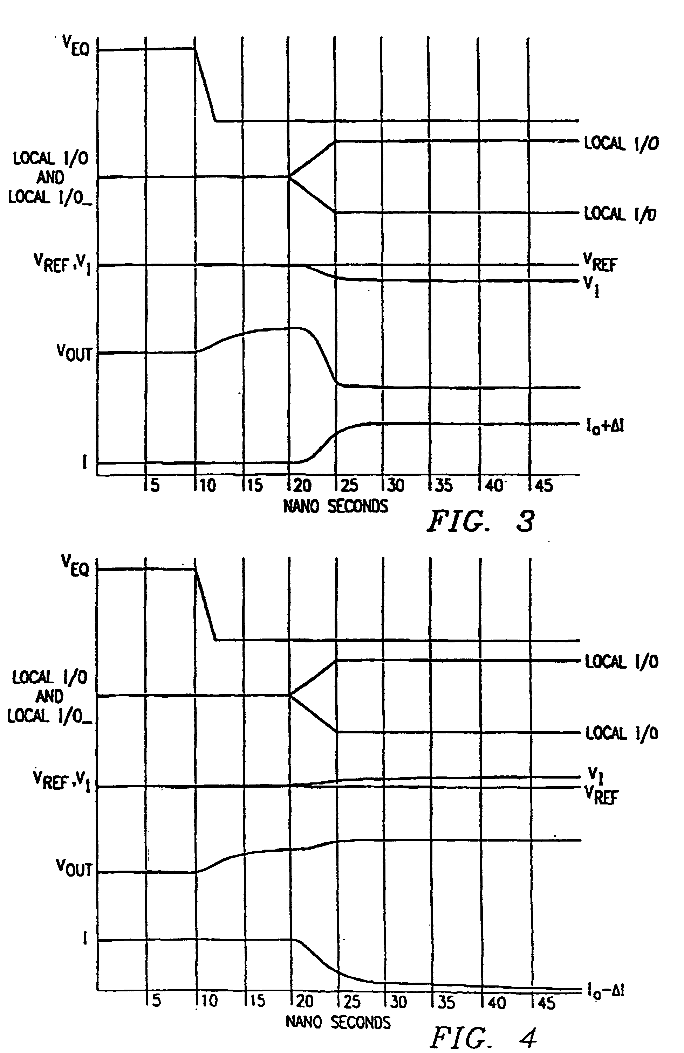

Referring to Figs. 3 and 4, simulated waveforms for the READ '0' transition (i.e., LOCAL I/O SIGNAL -> low, LOCAL I/O SIGNAL_ -> high) and the READ '1' (LOCAL I/O SIGNAL -> high, LOCAL I/O SIGNAL_ -> low), respectively are shown. During the first 20 nanoseconds, the voltage V₁ (i.e., the voltage applied to the gate terminal of transistor MN7) and the voltage V_{REF} (i.e., the voltage applied to the gate of transistor MN8) are equalized. After the equalization period, then the data read, '0' in Fig. 3 and '1' in Fig. 4, is initiated.

### OPERATION OF THE PREFERRED EMBODIMENTS

The general concept of the present non-differential, current mode data path is shown in Fig. 1. The LOCAL I/O SIGNALS (and their complements) are conventional full swing differential signals originating from sense amplifiers. These differential input signals are converted to non-differential, current mode signals with an approximately constant voltage and a current swing of Iₒ ± DELTA I. Because the voltage swing is limited (ideally zero), the capacitance of the data line has little effect on the propagation delay. At the receiver end of the data line, the current mode signal is converted to a full swing CMOS output signal level suitable for use by the coupled circuitry. The current-to-full swing conversion is accomplished in practice in two increments. The first increment converts the current swing to a small swing voltage signal Vₒ ± DELTA V. This small swing voltage signal is then converted to a full swing CMOS level by the second stage.

The implementation of the non-differential, current mode data line, according to the present invention is shown in Fig. 2. The differential voltage of the LOCAL I/O SIGNALS is converted to a signal voltage output using a differential amplifier (i.e., transistors MP1-MP2 and MN1-MN3). The output of the differential amplifier drives the gate of transistor MP3, the transistor MP3 modulating the current through the data line. The voltage applied to the gate of transistor MP3 is limited by transistors MP4 and MN4 to ensure that the transistor MP3 remains in saturation. At the receiver end of the data line, a current mirror is formed by transistors MN5 and MN6. The mirrored current through MN6 is passed through a diode-connected transistor MP5, thereby creating a voltage swing at the gate of transistor MN7.

In the typical differential data line implementation, the conversion to a full voltage swing signal is easily accomplished because the differential voltage between the two lines is increasing either positively or negatively. For the non-differential situation, this conversion is more difficult because the voltage signal is swinging around the positive voltage. To perform the conversion in the preferred embodiment voltage applied to the gate of transistor MN7 should be compared to a reference voltage. In the preferred embodiment, the reference voltage is supplied by a sample and hold technique, i.e., sampling the initial voltage a the gate of MN7 during precharge and holding this sampled voltage during the data sense operation. This sampling process eliminates the potential problem of having a reference voltage that shifts independently of the operation point of the data path circuitry, a process which could result in a reduced operation margin.

The comparator consists of a differential amplifier formed by transistors MP6-MP7 and MN7-MN9. The small swing voltage at the gate of transistor MN7 is coupled to one end of the differential amplifier. The voltage at the gate of transistor MN8 is generated before the sensing begins by bringing the EQ SIGNAL high. The LOCAL I/O SIGNALS are equalized at this time and the voltage at the gate of transistor MN7 is therefore at the equilibrium center value. With the EQ SIGNAL high, transistor MN10 is on, a condition which equalizes the voltage applied to the gate of transistor MN7 and the voltage applied to the gate of transistor MN8 and charges the capacitor C1. When the EQ SIGNAL turned off, capacitor C1 maintains the gate voltage of transistor MN8 at the precharged level. Once the LOCAL I/O SIGNALS separate, the gate voltage at transistor MN7 either swings up or swings down from the initial value, the polarity of the swing depending on the sensed state. The voltage V_{OUT} therefore swing positively or negatively, accordingly. In practice, an inverter or latch unit would be the next stage to ensure that the full swing voltage level is maintained.

While the invention has been described with particular reference to the preferred embodiment, it will be understood by those skilled in the art that various changes may be made and equivalents substituted for elements of the preferred embodiment without departing from the invention. In addition, many modifications may be made to adapt a particular situation and material to a teaching of the present invention without departing from the essential teachings of the present invention.

As is evident from the foregoing discussion, certain aspects of the invention are not limited to the particular details of the examples illustrated, and it is therefore contemplated that other modifications and applications will occur to those skilled in the art. For example, certain control signals needed to activate and coordinate the memory unit are not shown. Similarly, in the implementation of the present invention, provision would have to be made to eliminate the current drain when the device is in a standby mode of operation. It is accordingly intended that the claims shall cover all modifications and applications as do not depart from the scope of the invention.

## Claims

1. Circuitry for conducting a signal, comprising:
a differential voltage to current conversion circuit (5) having a first input for receiving a first signal (LOCAL I/O SIGNAL) having a voltage swing of a first magnitude, a second input for receiving a second signal (LOCAL I/O SIGNAL_) that is a complement of the first signal and having a voltage swing of said first magnitude, and transmitting a single current signal (I₀ +ΔI) responsive to the first and second signals (LOCAL I/O SIGNAL, LOCAL I/O SIGNAL_), the current signal (I₀ + ΔI) having a voltage swing of a second magnitude that is substantially smaller than said first magnitude; and
a current to voltage conversion circuit (10) for receiving said current signal (I₀ + ΔI) and for transmitting an output voltage (V_{OUT}) responsive to said current signal (I₀ + ΔI).

2. The circuitry of claim 1, wherein said current to voltage conversion circuit (10) further comprises:
a current to small-signal voltage conversion circuits (11) for receiving said current signal (I₀ + ΔI) and transmitting a small-signal voltage (V₀ + ΔV) having a voltage swing of a third magnitude; and
a small-signal to large-signal voltage conversion circuit (12) for receiving said small-signal voltage (V₀ + ΔV) and for transmitting said output voltage (V_{OUT}) responsive to said small-signal voltage, said output voltage having a voltage swing of a fourth magnitude that is substantially greater than said third magnitude.

3. The circuitry of claim 2, wherein said small-signal to large-signal voltage conversion circuit further comprises:
a differential circuit having at least two inputs and receiving said small-signal voltage at a first input.

4. The circuitry of claim 2 or claim 3, wherein said small-signal to large signal voltage conversion circuit further comprises:
a differential circuit having at least two inputs, wherein said two inputs are coupled together by the source-drain path of a transistor responsive to a control signal.

5. The circuitry of any preceding claim, wherein said current signal has a current magnitude which varies responsive to the differential voltage between the first signal and the second signal.

6. The circuitry of any preceding claim, wherein the voltage present at said two inputs of said differential circuit is made approximately equal responsive to a first logic state of said control signal

7. The circuitry of any preceding claim, wherein said differential circuit further comprises:
a sample and hold circuit coupled to one of said at least two inputs, said sample and hold circuit maintaining a reference voltage at said one of said at least two inputs responsive to a second logic state of said control signal.

8. The circuitry of any preceding claim, wherein the fourth magnitude voltage swing is approximately the magnitude of a Vdd supply voltage.

9. The circuitry of any preceding claim, wherein said signal being conducted is a data signal.

10. The circuitry of any preceding claim, wherein said signal being conducted is a data signal received from a sense amplifier.

11. A method for conducting a signal in a memory integrated circuit, comprising the steps of:
receiving a first signal (LOCAL I/O SIGNAL) having a voltage swing of a first magnitude;
receiving a second signal (LOCAL I/O SIGNAL_) which is a complement of said first signal, said second signal having a voltage swing of said first magnitude;
outputting a single ocurrent signal (I₀ + ΔI) responsive to said first and second signals, said current signal having a voltage swing of a second magnitude;
transmitting said current signal along a path; generating a first output voltage (V₀ + ΔV) responsive to said current signal (I₀ + ΔI), said first output voltage having a voltage swing of a third magnitude; and
generating a second output voltage (V_{OUT}) responsive to said first output voltage (V₀ + ΔV), said second output voltage having a voltage swing of a fourth magnitude that is substantially greater than said third magnitude.

12. The method of claim 11, wherein said first magnitude is substantially greater than said second magnitude.

13. The method of claim 11 or claim 12, wherein said third magnitude is substantially greater than said second magnitude.

14. The method of claim 11, claim 12 or claim 13, wherein said fourth magnitude is substantially greater than said second magnitude.

15. The method of any of claims 11 to 14, wherein said fourth magnitude is approximately equal to the magnitude of a Vdd supply voltage to the memory integrated circuit.

16. The method of any of claims 11 to 15, wherein said step of outputting a current signal comprises the step of outputting a signal with a substantially constant voltage and a variable current magnitude.

17. The method of any of claims 11 to 16, wherein said second magnitude is approximately zero.

18. The method of any of claims 11 to 17, wherein the step of generating a second output voltage further comprises the steps of:
receiving said first output voltage at a first input to a differential circuit;
receiving a reference voltage at a second input to said differential circuit; and
outputting said second output voltage, said second output voltage having a magnitude that is responsive to the difference between said first output voltage and said reference voltage.

19. The method of claim 18, wherein said step of receiving a reference voltage at a second input further comprises the steps of:
providing a voltage at said first input;
coupling said first and second inputs together responsive to a first logic state of a control signal; and
maintaining said voltage of said first input at said second input responsive to a second logic state of said control signal.

20. The method of claim 18 or claim 19, wherein the step of maintaining said voltage of said first input at said second input comprises the steps of:
providing a sample and hold circuit at said second input; and
storing said voltage of said first input in said sample and hold circuit.

21. The method of any of claims 11 to 20, wherein the method for conducting a signal further comprises the step of conducting a data signal.

22. A memory unit comprising:
a storage cell array;
a buffer unit;
a data line;
write apparatus for applying signals from said buffer unit through said data line to said storage cell array; and
read apparatus for applying signals from said storage cell array through said data line to said buffer unit, said read apparatus further comprising:
a differential voltage-to-current conversion unit (5) for receiving a differential signal and applying a single current signal (I₀ + ΔI) to said data line;
a current-to-small swing voltage conversion unit (11) for receiving said current signal (I₀ + ΔI) from said data line and generating a small swing voltage signal (V₀ + ΔV) therefrom; and a small swing voltage-to-full swing voltage conversion unit (12) for receiving said small swing voltage signal (V₀ + ΔV) and generating a full swing output voltage (V_{OUT}) therefrom.

## Patentansprüche

1. Schaltungsanordnung zum Leiten eines Signals, die umfasst:
eine differentielle Spannungs/Strom-Umsetzungsschaltung (5), die einen ersten Eingang, um eine erstes Signal (LOCAL I/O SIGNAL), das einen Spannungsausschlag mit einer ersten Größe besitzt, zu empfangen, und einen zweiten Eingang, um ein zweites Signal (LOCAL I/O SIGNAL_), das ein Komplement des ersten Signals ist und einen Spannungsausschlag der ersten Größe aufweist, zu empfangen, besitzt und in Reaktion auf das erste und das zweite Signal (LOCAL I/O SIGNAL, LOCAL I/O SIGNAL_) ein einzelnes Stromsignal (I₀ + ΔI) sendet, wobei das Stromsignal (I₀ + ΔI) einen Spannungsausschlag einer zweiten Größe, die wesentlich kleiner als die erste Größe ist, aufweist; und
eine Strom/Spannung-Umsetzungsschaltung (10), die das Stromsignal (I₀ + ΔI) empfängt und in Reaktion auf das Stromsignal (I₀ + ΔI) eine Ausgangsspannung (V_{OUT}) sendet.

2. Schaltungsanordnung nach Anspruch 1, bei der die Strom/Spannungs-Schaltung (10) ferner umfasst:
eine Strom/Kleinsignalspannung-Umsetzungsschaltung (11), die das Stromsignal (I₀ + ΔI) empfängt und eine Kleinsignalspannung (V₀ + ΔV), die einen Spannungsausschlag einer dritten Größe besitzt, sendet; und
eine Kleinsignalspannung/Großsignalspannung-Umsetzungsschaltung (19), die die Kleinsignalspannung (V₀ + ΔV) empfängt und in Reaktion auf die Kleinsignalspannung die Ausgangsspannung (V_{OUT}) sendet, wobei die Ausgangsspannung einen Spannungsausschlag einer vierten Größe besitzt, die wesentlich größer als die dritte Größe ist.

3. Schaltungsanordnung nach Anspruch 2, bei der die Kleinsignalspannung/Großsignalspannung-Umsetzungsschaltung ferner umfasst:
eine differentielle Schaltung, die wenigstens zwei Eingänge besitzt und an einem ersten Eingang die Kleinsignalspannung empfängt.

4. Schaltungsanordnung nach Anspruch 2 oder Anspruch 3, bei der die Kleinsignalspannung/Großsignalspannung-Umsetzungsschaltung ferner umfasst:
eine differentielle Schaltung, die wenigstens zwei Eingänge besitzt, wobei die zwei Eingänge in Reaktion auf ein Steuersignal über den Source/Drain-Pfad eines Transistors miteinander gekoppelt werden.

5. Schaltungsanordnung nach einem vorhergehenden Anspruch, bei der das Stromsignal eine Stromgröße besitzt, die sich in Reaktion auf die differentielle Spannung zwischen dem ersten Signal und dem zweiten Signal ändert.

6. Schaltungsanordnung nach einem vorhergehenden Anspruch, bei der die an den beiden Eingängen der differentiellen Schaltung anliegenden Spannungen in Reaktion auf einen ersten logischen Zustand des Steuersignals ungefähr gleich gemacht werden.

7. Schaltungsanordnung nach einem vorhergehenden Anspruch, bei der die differentielle Schaltung ferner umfasst:
eine Abtast/Halte-Schaltung, die mit einem der wenigstens zwei Eingänge gekoppelt ist, wobei die Abtast/Halte-Schaltung in Reaktion auf einen zweiten logischen Zustand des Steuersignals eine Referenzspannung an dem einen der wenigstens zwei Eingänge aufrechterhält.

8. Schaltungsanordnung nach einem vorhergehenden Anspruch, bei der der Spannungsausschlag der vierten Größe ungefähr gleich der Größe einer Vdd-Versorgungsspannung ist.

9. Schaltungsanordnung nach einem vorhergehenden Anspruch, bei der das geleitete Signal ein Datensignal ist.

10. Schaltungsanordnung nach einem vorhergehenden Anspruch, bei der das geleitete Signal ein Datensignal ist, das von einem Leseverstärker empfangen wird.

11. Verfahren zum Leiten eines Signals in einer integrierten Speicherschaltung, das die folgenden Schritte umfasst:
Empfangen eines ersten Signals (LOCAL I/O SIGNAL), das einen Spannungsausschlag einer ersten Größe besitzt;
Empfangen eines zweiten Signals (LOCAL I/O SIGNAL_), das ein Komplement des ersten Signals ist und einen Spannungsausschlag der ersten Größe besitzt;
Ausgeben eines einzelnen Stromsignals (I₀ + ΔI) in Reaktion auf das erste und das zweite Signal, wobei das Stromsignal einen Spannungsausschlag einer zweiten Größe besitzt;
Senden des Stromsignals längs eines Weges;
Erzeugen einer ersten Ausgangsspannung (V₀ + ΔV) in Reaktion auf das Stromsignal (I₀ + ΔI), wobei die erste Ausgangsspannung einen Spannungsausschlag einer dritten Größe besitzt; und
Erzeugen einer zweiten Ausgangsspannung (Vₒᵤₜ) in Reaktion auf die erste Ausgangsspannung (V₀ + ΔV), wobei die zweite Ausgangsspannung einen Spannungsausschlag einer vierten Größe besitzt, die wesentlich größer als die dritte Größe ist.

12. Verfahren nach Anspruch 11, bei dem die erste Größe wesentlich größer als die zweite Größe ist

13. Verfahren nach Anspruch 11 oder Anspruch 12, bei dem die dritte Größe wesentlich größer als die zweite Größe ist

14. Verfahren nach Anspruch 11, Anspruch 12 oder Anspruch 13, bei dem die vierte Größe wesentlich größer als die zweite Größe ist.

15. Verfahren nach einem der Ansprüche 11 bis 14, bei dem die vierte Größe ungefähr gleich der Größe einer Vdd-Versorgungsspannung an der integrierten Speicherschaltung ist.

16. Verfahren nach einem der Ansprüche 11 bis 15, bei dem der Schritt des Ausgebens eines Stromsignals den Schritt des Ausgebens eines Signals mit einer im Wesentlichen konstanten Spannung und einer veränderbaren Stromgröße umfasst.

17. Verfahren nach einem der Ansprüche 11 bis 16, bei dem die zweite Größe ungefähr null ist.

18. Verfahren nach einem der Ansprüche 11 bis 17, bei dem der Schritt des Erzeugens einer zweiten Ausgangsspannung ferner die folgenden Schritte umfasst:
Empfangen der ersten Ausgangsspannung an einem ersten Eingang in eine differentielle Schaltung;
Empfangen einer Referenzspannung an einem zweiten Eingang in die differentielle Schaltung; und
Ausgeben der zweiten Ausgangsspannung, wobei die zweite Ausgangsspannung eine Größe besitzt, die sich in Reaktion auf die Differenz zwischen der ersten Ausgangsspannung und der Referenzspannung ergibt.

19. Verfahren nach Anspruch 18, bei dem der Schritt des Empfangens einer Referenzspannung an einem zweiten Eingang ferner die folgenden Schritte umfasst:
Bereitstellen einer Spannung an dem ersten Eingang;
Koppeln des ersten Eingangs und des zweiten Eingangs miteinander in Reaktion auf einen ersten logischen Zustand eines Steuersignals; und
Aufrechterhalten der Spannung des ersten Eingangs an dem zweiten Eingang in Reaktion auf einen zweiten logischen Zustand des Steuersignals.

20. Verfahren nach Anspruch 18 oder Anspruch 19, bei dem der Schritt des Aufrechterhaltens der Spannung des ersten Eingangs an dem zweiten Eingang die folgenden Schritte umfasst:
Vorsehen einer Abtast/Halte-Schaltung an dem zweiten Eingang; und
Speichern der Spannung des ersten Eingangs in der AbtastlHalte-Schaltung.

21. Verfahren nach einem der Ansprüche 11 bis 20, wobei das Verfahren zum Leiten eines Signals ferner den Schritt des Leitens eines Datensignals umfasst.

22. Speichereinheit, die umfasst:
eine Speicherzellenmatrix;
eine Puffereinheit;
eine Datenleitung;
eine Schreibvorrichtung zum Eingeben von Signalen von der Puffereinheit über die Datenleitung in die Speicherzellenmatrix; und
eine Lesevorrichtung zum Eingeben von Signalen von der Speicherzellenmatrix über die Datenleitung in die Puffereinheit, wobei die Lesevorrichtung ferner umfasst:
eine differentielle Spannungs/Strom-Umsetzungseinheit (5), die ein differentielles Signal empfängt und ein einziges Stromsignal (I₀ + ΔI) in die Datenleitung eingibt;
eine Strom/Niedrigausschlagsspannung-Umsetzungseinheit (11), die das Stromsignal (I₀ + ΔI) von der Datenleitung empfängt und hieraus ein Niedrigausschlagspannungssignal (V₀ + ΔV) erzeugt; und
eine Niedrigausschlagspannung/Vollausschlagspannung-Umsetzungseinheit (12), die das Niedrigausschlagspannungssignal (V₀ + ΔV) empfängt und hieraus eine Vollausschlagausgangsspannung (V_{OUT}) erzeugt.

## Revendications

1. Circuit pour transférer un signal, comprenant :
un circuit de conversion différentiel tension vers intensité (5), comprenant une première entrée pour recevoir un premier signal (signal local E/S) ayant une oscillation de tension d'une première amplitude, une deuxième entrée pour recevoir un deuxième signal (signal local E/S) qui est un complément du premier signal et ayant une oscillation de tension de ladite première amplitude, et transmettre un signal de courant unique (I₀ + ΔI) en réponse aux premier et deuxième signaux (signal local E/S, signal local E/S), le signal d'intensité (I₀ + ΔI) ayant une première oscillation de tension d'une deuxième amplitude sensiblement inférieure à ladite première amplitude ; et un circuit de conversion intensité vers tension (10) pour recevoir ledit signal d'intensité (I₀ + ΔI) et pour transmettre une tension de sortie (Vₒᵤₜ) en réponse audit signal d'intensité (I₀ + ΔI).

2. Circuit selon la revendication 1, dans lequel ledit circuit de conversion intensité vers tension (10) comprend en outre :
un circuit de conversion intensité vers petite tension de signal (11), pour recevoir ledit signal d'intensité (I₀ + ΔI) et transmettre une tension de petit signal (I₀ + ΔV) ayant une oscillation de tension d'une troisième amplitude ; et
un circuit de conversion de tension de petit signal vers grand signal (12), pour recevoir ladite tension de petit signal (V₀ + ΔV) et transmettre ledit signal de sortie (Vₒᵤₜ) en réponse à ladite tension de petit signal, ladite tension de sortie ayant une oscillation de tension d'une quatrième amplitude sensiblement supérieure à la dite troisième amplitude.

3. Circuit selon la revendication 2, dans lequel le circuit de conversion de petit signal vers grand signal de tension comprend en outre un circuit différentiel ayant au moins deux entrées et recevant ladite tension de petit signal à une première entrée.

4. Circuit selon la revendication 2 ou 3, dans lequel ledit circuit de conversion de tension de petit signal vers grand signal comprend en outre :
un circuit différentiel ayant au moins deux entrées, dans lequel lesdites deux entrées sont couplées ensemble par le chemin source-drain d'un transistor en réponse à un signal de commande.

5. Circuit selon l'une des revendications précédentes, dans lequel ledit signal d'intensité est d'une amplitude d'intensité variant en réponse à la tension différentielle que l'on a entre le premier signal et le deuxième signal.

6. Circuit selon l'une quelconque des revendications précédentes, dans lequel la tension présente auxdites deux entrées dudit circuit différentiel est rendue approximativement égale, en réponse à un premier état logique dudit signal de commande.

7. Circuit selon l'une quelconque des revendications précédentes, dans lequel ledit circuit différentiel comprend en outre :
un circuit d'échantillonnage et de maintien couplé à l'une desdites au moins deux entrées, ledit circuit d'échantillonnage et de maintien maintenant une tension de référence à ladite première des au moins deux entrées, en réponse à un deuxième état logique dudit signal de commande.

8. Circuit selon l'une quelconque des revendications précédentes, dans lequel l'oscillation de tension de la quatrième amplitude est approximativement de l'amplitude d'une tension d'alimentation Vdd.

9. Circuit selon l'une quelconque des revendications précédentes, dans lequel ledit signal transmis est un signal de données.

10. Circuit selon l'une quelconque des revendications précédentes, dans lequel ledit signal transmis est un signal de données reçu d'un amplificateur de détection.

11. Procédé de transmission d'un signal dans un circuit intégré de mémoire, comprenant les étapes consistant à :
- recevoir un premier signal (signal local E/S) ayant une oscillation de tension d'une première amplitude ;
- recevoir un deuxième signal (signal local E/S) qui est un complément dudit premier signal, ledit deuxième signal ayant une oscillation de tension de ladite première amplitude ;
- fournir un signal d'intensité unique (I₀ + ΔI) en réponse auxdits premier et deuxième signaux, ledit signal d'intensité ayant une oscillation de tension d'une deuxième amplitude ;
- transmettre ledit signal d'intensité sur un chemin ;
- générer une première tension de sortie (V₀ + ΔV) en réponse audit signal d'intensité (I₀ + ΔI), ladite première tension de sortie ayant une oscillation de tension d'une troisième amplitude ; et
- générer une deuxième tension de sortie (Vₒᵤₜ) en réponse à ladite première tension de sortie (V₀ + ΔV), ladite deuxième tension de sortie ayant une oscillation de tension d'une quatrième amplitude, sensiblement supérieure à ladite troisième amplitude.

12. Procédé selon la revendication 11, dans lequel ladite première amplitude est sensiblement supérieure à ladite deuxième amplitude.

13. Procédé selon la revendication 11 ou 12, dans lequel ladite troisième amplitude est sensiblement supérieure à ladite deuxième amplitude.

14. Procédé selon la revendication 11, la revendication 12 ou la revendication 13, dans lequel ladite quatrième amplitude est sensiblement supérieure à ladite deuxième amplitude.

15. Procédé selon l'une quelconque des revendications 11 à 14, dans lequel ladite quatrième amplitude est approximativement égale à l'amplitude d'une tension d'alimentation Vdd au circuit intégré de mémoire.

16. Procédé selon l'une quelconque des revendications 11 à 15, dans lequel ladite étape de fourniture d'un signal d'intensité comprend l'étape de fourniture d'un signal ayant une tension sensiblement constante et une amplitude d'intensité variable.

17. Procédé selon l'une quelconque des revendications 11 à 16, dans lequel ladite deuxième amplitude est d'environ zéro.

18. Procédé selon l'une quelconque des revendications 11 à 17, dans lequel l'étape de génération d'une deuxième tension de sortie comprend en outre les étapes consistant à :
- recevoir ladite première tension de sortie à une première entrée d'un circuit différentiel ;
- recevoir une tension de référence à une deuxième entrée dudit circuit différentiel ; et
- fournir ladite deuxième tension de sortie, ladite deuxième tension de sortie ayant une amplitude en réponse à la différence entre ladite première tension de sortie et ladite tension de référence.

19. Procédé selon la revendication 18, dans lequel ladite étape de réception d'une tension de référence à une deuxième entrée comprend en outre les étapes consistant à :
- fournir une tension à ladite première entrée ;
- coupler lesdites première et deuxième entrée ensemble en réponse à un premier état logique d'un signal de commande ; et
- maintenir ladite tension de ladite première entrée à ladite deuxième entrée en réponse à un deuxième état logique dudit signal de commande.

20. Procédé selon la revendication 18 ou la revendication 19, dans lequel l'étape de maintien de ladite tension de ladite première entrée à ladite deuxième entrée comprend les étapes consistant à :
- fournir un circuit d'échantillonnage et de maintien à ladite deuxième entrée ; et
- stocker ladite tension de ladite première entrée dans ledit circuit d'échantillonnage et de maintien.

21. Procédé selon l'une quelconque des revendications 11 à 20, dans lequel le procédé de transmission d'un signal comprend en outre l'étape de transmission d'un signal de données.

22. Une unité mémoire comprenant :
- une matrice de cellule de stockage ;
- une unité tampon ;
- une ligne de données ;
- un dispositif d'écriture, pour appliquer des signaux de ladite unité de tampon en passant par ladite ligne de données à ladite matrice de cellule de stockage ; et
- un dispositif de lecture, pour appliquer des signaux venant de ladite matrice de cellule de stockage par ladite ligne de données à ladite unité tampon, ledit dispositif de lecture comprenant en outre :
- une unité de conversion différentielle tension vers intensité (5), pour recevoir un signal différentiel et appliquer un signal d'intensité unique (I₀ + ΔI) à ladite ligne de données ;
- une unité de conversion intensité vers tension à petit oscillation (11), pour recevoir ledit signal d'intensité (I₀ + ΔI) venant de ladite ligne de données et générer à partir de cela un signal de tension à petite oscillation (V₀ + ΔV) ; et
- une unité de conversion tension à petite oscillation vers tension à pleine oscillation (12), pour recevoir ledit signal de tension à petite oscillation (V₀ + ΔV) et générer à partir de cela une tension de sortie de pleine oscillation (Vₒᵤₜ).
